# FASCICULE DE BREVET EUROPEEN

(11) **EP 0 354 619 B1**
(45) Date de publication et mention de la délivrance du brevet: **05.03.1997**
(21) Numéro de dépôt: 89202038.9
(22) Date de dépôt: 04.08.1989
(51) Int. Cl.: H01L 27/148

(54) **Dispositif capteur d'images du type à transfert de trame**
Bildaufnahmevorrichtung vom Halbbildübertragungstyp
Image sensor of the frame transfer type

(30) Priorité: 10.08.1988 FR 8810786
(43) Date de publication de la demande: 14.02.1990
(73) Titulaire: Philips Electronics N.V., 5621 BA Eindhoven (NL)
(72) Inventeur: Bakker, Jacobus, NL-5656 AA Eindhoven (NL); Collet, Marnix, NL-5656 AA Eindhoven (NL)
(74) Mandataire: Houbiers, Ernest Emile Marie Gerlach

(56) Documents cités:
- EP-A- 0 139 366
- EP-A- 0 275 180
- GB-A- 2 134 710

## Description

L'invention a pour objet un dispositif capteur d'images à transfert de trames comportant un substrat semi-conducteur présentant une première région (10) d'un premier type de conductivité, une deuxième région d'un deuxième type de conductivité opposé au premier, disposée au-dessus de la première région du substrat et s'étendant jusqu'à la face supérieure du substrat, des canaux parallèles de transfert de charges du premier type de conductivité disposés dans la deuxième région à la face supérieure du substrat selon une direction de transfert de charges, ainsi qu'un arrangement d'électrodes de transfert de charges disposées perpendiculairement aux canaux parallèles sur la face supérieure du substrat et isolées électriquement de celle-ci, l'arrangement d'électrodes présentant un arrangement de fenêtres de manière à permettre, lorsque les électrodes sont portées à des potentiels appropriés, le transfert de charges d'un premier signe, stockées dans des cellules élémentaires en réponse à une lumière incidente, dans la direction de transfert de charges le long desdits canaux prallèles.

De la demande de brevet européen n°143 496 déposé par la Demanderesse, un capteur d'images du type à transfert de trames est connu. Dans cette antériorité, les régions de canal sont photosensibles et il en résulte que l'efficacité est limitée par la présence de l'arrangement d'électrodes de transfert de charges. Un dispositif correspondant à la première partie de la revendication 1 est connu de GB-A-2 134 710. Dans cette antériorité l'arrangement d'électrodes est prévu de fenêtres pour améliorer l'efficacité. Néanmoins, l'efficacité reste assez limitée.

Il a par ailleurs été proposé pour des capteurs d'image du type à interlignage de disposer une couche photosensible sur toute la surface du cristal et de connecter électriquement par des électrodes cette couche photosensible point par point à des zones d'accumulation de charge. On trouvera un exemple d'un tel capteur dans la demande de brevet européen n° 139 366. Un capteur similaire présentant un réseau de bandes séparatrices disposées sur la totalité du contour des régions de fenêtre est décrit dans EP-A-0 275 180.

Le transfert des charges est effectué, comme il est classique avec ce type de capteur d'image, grâce à un canal de transfert distinct des zones d'accumulation de charges.

Le fait de disposer une couche photosensible sur toute la surface du cristal présente l'avantage d'augmenter l'efficacité du dispositif, puisqu'aucun facteur géométrique ne vient réduire la dimension de la surface sensible.

Cependant, la structure décrite est absolument spécifique d'un capteur d'image du type à interlignage (I.L). En effet, dans de tels capteurs, comme les zones d'accumulation de charges et les canaux de transfert de charges sont séparés les uns des autres, les interconnexions sont réalisées grâce à des structures multicouches classiques dans l'industrie des semiconducteurs.

L'invention propose, pour un dispositif capteur d'images du type à transfert de trames, de disposer une couche photo-sensible sur toute la surface du cristal, de manière à lui conférer une efficacité accrue.

Les structures actuellement connues pour les capteur du type à interlignage (I.L) sont, comme mentionné ci-dessus, spécifiques de tels capteurs. Leur mise en oeuvre dans des dispositifs à transfert de trames conduirait à utiliser une part notable de la surface disponible pour intercaler notamment des électrodes connectant la couche photosensible et des régions de transfert de charges.

L'idée de base de l'invention est de réaliser dans l'arrangement d'électrodes au moins une fenêtre par cellule élémentaire, à travers lesquelles la couche photo-sensible est mise en contact électrique avec un canal de transfert de charges.

Un problème des dispositifs capteurs d'image à couplage de charge est celui de brouillage d'image (en anglais "smear") qui est dû à un transfert indésirable vers les canaux de transfert de charges, des charges qui, lors de la phase de transfert de trames, sont générées dans les régions de fenêtre recevant une intensité lumineuse élevée. Une manifestation de ce phénomène est par exemple qu'un point lumineux isolé dans un fond sombre est reproduit dans l'image avec une traînée dans la direction de transfert de charges. Ce phénomène ne doit pas être confondu avec le flou dû à l'éblouissement (en anglais "blooming"), phénomène localisé qui est dû à un excédent des charges générées pendant la phase d'intégration.

L'idée de base de l'invention pour résoudre le problème de brouillage est de disposer des électrodes destinées à être portées à un potentiel du deuxième signe, par exemple positif, pendant la phase de transfert de trames de manière à capter les charges de premier signe, dans cet exemple les électrons générés durant la phase de transfert de charges.

Dans ce but, le dispositif selon l'invention est caractérisé en ce qu'il comporte une couche photosensible qui recouvre l'arrangement d'électrodes et en est électriquement isolée, en ce qu' au moins une région de fenêtre de la couche photosensible est, pour chaque cellule élémentaire, localement en contact électrique avec un des canaux parallèles à travers les fenêtres formées dans l'arrangement d'électrodes, en ce qu'à l'arrangement d'électrodes est superposé un réseau de bandes séparatrices disposées sur la totalité du contour des régions de fenêtre de manière à éviter la dérive des charges du premier signe entre les régions de fenêtre, et à évacuer les charges du deuxième signe opposé au premier, ledit réseau présentant des bandes conductrices du deuxième type de conductivité bordant selon au moins une direction les régions de fenêtres de l'arrangement de fenêtres, et en ce qu'à l'arrangement d'électrodes de transfert de charges est superposée au moins une électrode supérieure isolée électriquement des électrodes de transfert de charges et de la couche photosensible et connectée à une source de tension fournissant un premier potentiel du premier signe et un deuxième potentiel du deuxième signe, de manière à diminuer le brouillage d'image lorsque l'électrode supérieure est portée au premier potentiel du premier signe lors d'une phase d'intégration d'image et au deuxième potentiel du deuxième signe lors d'une phase de transfert de charges.

Cette structure présente plusieurs avantages. D'une part, les canaux de transfert de charges restent espacés de la même façon que dans les capteurs à transfert de trames connus. D'autre part, l'arrangement d'électrodes, disposé entre les canaux parallèles et la couche photosensible, peut être réalisé de la même façon que dans le cas des dispositifs à transfert de trames traditionnels, les fenêtres ménagées dans l'arrangement d'électrodes et qui sont en pratique de faibles dimension ayant par ailleurs une influence négligeable sur la répartition du potentiel dans les canaux. Enfin, les bandes séparatrices évitent la dérive des charges du premier signe et permettent l'évacuation des charges du deuxième signe.

Selon une première variante, l'arrangement de fenêtres comporte par cellule élémentaire au moins une fenêtre ménagée à travers au moins une électrode de l'arrangement d'électrodes.

Selon un mode de réalisation particulièrement avantageux de cette variante, le dispositif capteur d'images est du type à entrelacement, et l'arrangement d'électrodes présente deux fenêtres pour chaque cellule élémentaire, qui sont localisées sur deux électrodes de transfert de charges non adjacentes et séparées par au moins une électrode de transfert de charges.

Selon une deuxième variante, l'arrangement de fenêtres présente des bandes parallèles aux électrodes de transfert de charges de l'arrangement d'électrodes, chaque bande de l'arrangement de fenêtres étant disposée dans un intervalle entre deux électrodes de transfert de charges, et lesdites bandes étant interrompues entre les cellules élémentaires par celles desdites bandes séparatrices qui sont parallèles à la direction de transfert de charges.

La couche photosensible est avantageusement constituée d'une couche de Si dopé recristallisé, le substrat étant également en Si. La couche de Si dopé recristallisé est du premier type de conductivité, par exemple n, et les prolongements assurant la continuité électrique des régions de fenêtre de la couche photosensible avec les canaux, également en Si dopé recristallisé du premier type conductivité et de même dopage, par exemple n dopé à 5.10¹⁵ atomes/cm³ (at/cm³) pour des canaux de transfert de charges ayant un dopage compris entre 1 et 4.10¹⁶ at/cm³.

La couche de Si dopé recristallisé peut être du premier type de conductivité, par exemple p dopé à 5.10¹⁵at/cm³ et les prolongements également en Si dopé recristallisé du deuxième type de conductivité, mais de dopage plus élevé, par exemple p dopé à 2.10¹⁶ at/cm³, pour des canaux de transfert de charges de type n ayant un dopage compris entre 1 et 4.10¹⁶ at/cm³. Dans ce dernier cas, le plus fort dopage des prolongements a pour fonction d'éviter qu'ils soient complètement appauvris en charges.

Selon une première forme de mise en oeuvre, le brouillage d'image peut être au moins en grande partie supprimé grâce au fait qu'à l'arrangement d'électrode de transfert de charges, est superposée au moins une électrode supérieure isolée des électrodes de transfert de charges, et disposée sous la couche photosensible, et destinée à être portée à un premier potentiel du premier signe lors d'une phase d'intégration d'image et à un deuxième potentiel du deuxième signe lors d'une phase de transfert de charges.

Selon un premier mode de réalisation avantageux de cette première forme de mise en oeuvre, ladite électrode supérieure est réfléchissante. Ceci améliore la suppression de brouillage d'image car seule une faible proportion de rayonnement lumineux incident peut atteindre les canaux de transfert de charges. Sans cela, le spectre rouge en particulier pourrait atteindre directement les canaux de transfert de charges et y générer des paires électron-trou, particulièrement indésirables lors de la phase de transfert de charges.

Selon un deuxième mode de réalisation avantageux de cette première forme de mise en oeuvre, des îlots non transparents de dimension sensiblement supérieure à celle des fenêtres sont disposés à la surface de la couche photosensible et à l'aplomb des fenêtres. Il en résulte une suppression quasi-totale du phénomène de brouillage au prix d'une occultation d'une faible part de la surface photosensible.

Selon une deuxième forme de mise en oeuvre, le brouillage d'image peut être au moins en grande partie supprimé grâce au fait qu'une électrode transparente est disposées sur au moins une partie de la surface de la couche photosensible et isolée électriquement de celle-ci, cette électrode transparente étant destinée à être portée à un premier potentiel du premier signe lors d'une phase d'intégration d'image, et à un deuxième potentiel du deuxième signe lors d'une phase de transfert de charge.

Selon un mode de réalisation avantageux de cette deuxième forme de mise en oeuvre, les électrodes de transfert de charges sont réfléchissantes. De la sorte, seule une faible proportion du rayonnement lumineux incident peut atteindre les canaux de transfert de charges.

Selon un autre mode de réalisation de cette deuxième forme de mise en oeuvre, le brouillage d'image est pratiquement supprimé grâce au fait qu'entre la couche photosensible et l'arrangement d'électrodes, et électriquement isolée de ce dernier, est disposée à chaque région de fenêtre, une région conductrice réfléchissante en contact électrique avec la couche photosensible, les régions conductrices étant séparées entre elles selon un réseau de bandes de séparation isolantes à l'aplomb desquelles peuvent être disposées des lignes réfléchissantes, par exemple disposées en dessous des bandes de séparation et noyées dans un matériau isolant.

On obtient ainsi une suppression quasi-totale du phénomène de brouillage sans occultation d'aucune partie de la surface photosensible, mais au prix d'une relative complication de la fabrication.

Selon une troisième forme de mise en oeuvre, convenant plus particulièrement à la deuxième variante de l'arrangement de fenêtres, des bandes d'électrodes, de préférence non transparentes, sont disposées à l'aplomb des bandes de l'arrangement de fenêtres.

L'invention sera mieux comprise à la lecture de la description qui va suivre, donnée à titre d'exemple non limitatif, en liaison avec les dessins qui représentent :
- la figure 1a et la figure 1b un capteur d'images à transfert de trames de l'art antérieur en coupe respectivement dans l'axe d'un canal et perpendiculairement aux canaux.
- les figures 2 et 3, deux variantes d'un capteur d'images selon l'invention en coupe perpendiculairment aux canaux, la figure 4 étant une coupe de la figure 3 dans l'axe d'un canal.
- les figures 5 et 6 deux autres variantes d'un capteur d'images selon l'invention en coupe perpendiculairement aux canaux.
- la figure 7, une vue de dessus de la figure 6
- la figure 8, les tensions aux bornes des électrodes 1A, 1B, 1C, 1D et 2 au cours d'un cycle.
- la figure 9 une vue de dessus schématique d'un mode de réalisation préféré de l'invention, et les figures 10a et 10b des coupes réalisées respectivement perpendiculairement à l'axe des électrodes de transfert de charges, et parallèlement à celles-ci dans un intervalle inter-électrodes.

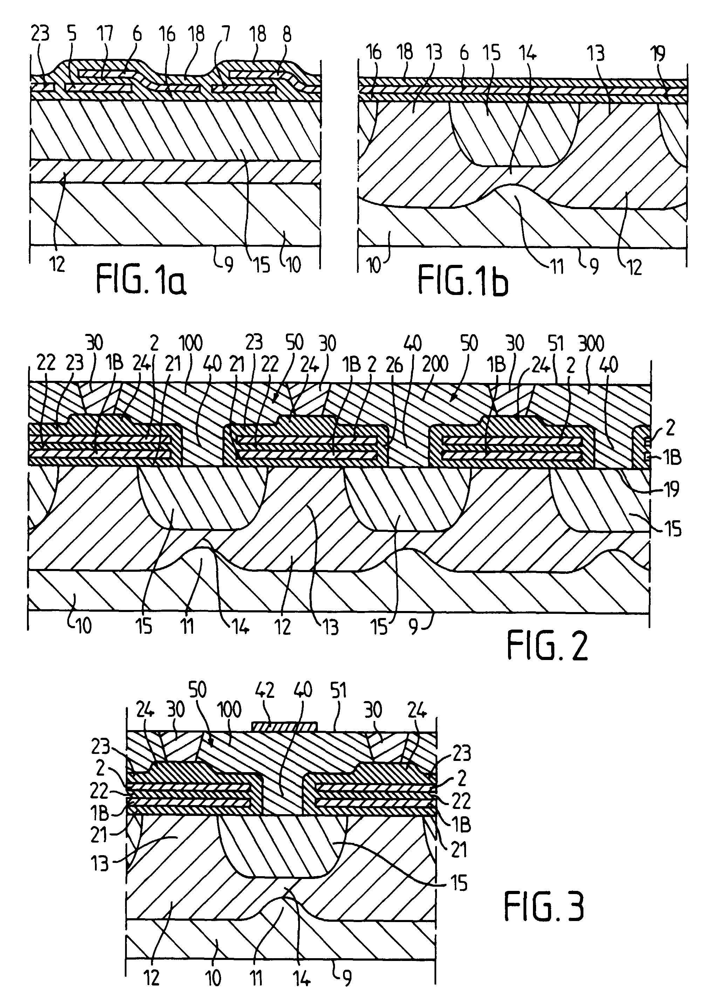

Selon les figures 1a et 1b, un dispositif capteur d'images de l'art antérieur à transfert de trame comporte un substrat présentant une région 10 de type n⁻ de dopage compris entre 2.10¹⁴ et 8.10¹⁴at/cm³, une région 12 de type p⁻ de dopage compris entre 1 et 5.10¹⁵at/cm³ disposée au-dessus de la région 10, et s'étendant jusqu'à la face supérieure 19 du substrat. Des canaux longitudinaux 15 de type n de dopage compris entre 10¹⁶ et 4.10¹⁶at/cm³ sont diffusés ou implantés à partir de la face supérieure 19 du substrat à une profondeur d'environ 1 µm. Les canaux 15 ont non seulement pour fonction de réaliser un transfert des charges, mais constituent également les régions photosensibles du capteur d'images. Les portions 13 de la région 12 situées entre les canaux 15 sont généralement plus dopées que le reste de la région 12 (2.10¹⁶-10¹⁸at/cm³) de manière à constituer des zones efficaces d'interruption de canal propres à empêcher la dérive des charges d'un canal vers les canaux adjacents. Enfin un arrangement d'électrodes comportant des motifs répétitifs d'électrodes 5 à 8 en polysilicium transparentes et perpendiculaires aux canaux 15, pour un dispositif classique à entrelacement et à quatre phases, est réalisé sur la face supérieure du substrat, les électrodes étant isolées les uns des autres par des couches isolantes de SiO₂ 16, 17 et 18.

En outre, et dans le cas où une correction de l'éblouissement est souhaitée, la région 10 présente un profil longitudinal 11 incurvé vers le haut en dessous des canaux 15, de manière à amincir en 14 la région 12 ce qui permet à l'exédent de charges produit en cas de surintensité lumineuse d'être évacué dans la région 10.

La région 12 peut être réalisée par diffusion, implantation ou épitaxie, les profils longitudinaux 11 pouvant être réalisés à partir de la face supérieure du substrat à travers un masque présentant des bandes, après diffusion ou implantation des régions 12.

On rappelera brièvement le fonctionnement d'un tel capteur d'images. Pendant la période d'intégration, des paires électron-trou sont produites dans les canaux photosensibles 15 par la lumière incidente. Pendant la période de transfert de trame, les électrons ainsi produits sont transférés pas à pas le long des canaux 15 jusqu'à ce que la trame toute entière ait été transférée. Ceci est obtenu par la polarisation adéquate et cadencée des électrodes 20 à 23.

Dans un tel dispositif, l'efficacité est limitée par le fait que la lumière doit traverser l'arrangement d'électrodes et les couches d'oxydes, et par le fait que les zones d'interruption de canal (13) ont une sensibilité atténuée lorsqu' elles sont très dopées.

Selon l'invention, l'arrangement d'électrodes disposé à la surface supérieure 19 est recouvert par une couche photosensible 50, et des fenêtres 40 sont ménagées pour assurer une continuité électrique entre la couche 50 et les canaux 15 qui ne remplissent qu'une fonction de transfert de charges. La face supérieure du dispositif est de la sorte entièrement occupée par la surface photosensible, à l'exception de bandes conductrices étroites 30 qui ont pour fonction d'évacuer les trous des paires électron-trou.

Plus particulièrement à la figure 2, le substrat comporte de la même façon que précédemment décrit les régions 10, 12, 13, et éventuellement 11 et 14, ainsi que les canaux 15. L'arrangement d'électrodes présente des fenêtres 40, à raison d'au moins une par cellule élémentaire à travers lesquelles la continuité électrique des régions de fenêtre (100, 200) de la région photoconductrice 50 est assurée avec les canaux 15 par des prolongements des régions 50. A titre d'exemple, et pour les dopages du substrat tels que exemplifiés précédemment, la région 50 et ses prolongements 40 peuvent être en Si recristallisé de type n dopé à 5.10¹⁵at/cm³ ou bien toutes les deux en Si recristallisé de type p, la région 50 étant dopée à 5.10¹⁵at/cm³ et les prolongements 40 ayant un dopage plus élevé, à savoir 2.10¹⁶at/cm³, ceci afin d'éviter qu'ils se trouvent en état d'appauvrissement complet. Dans ce dernier cas, on réalise les prolongements 40 après ouverture des fenêtres dans l'oxyde, puis la couche 50 sur toute la surface et on effectue ensuite l'opération de recristallisation de la couche 50 et des prolongements 40.

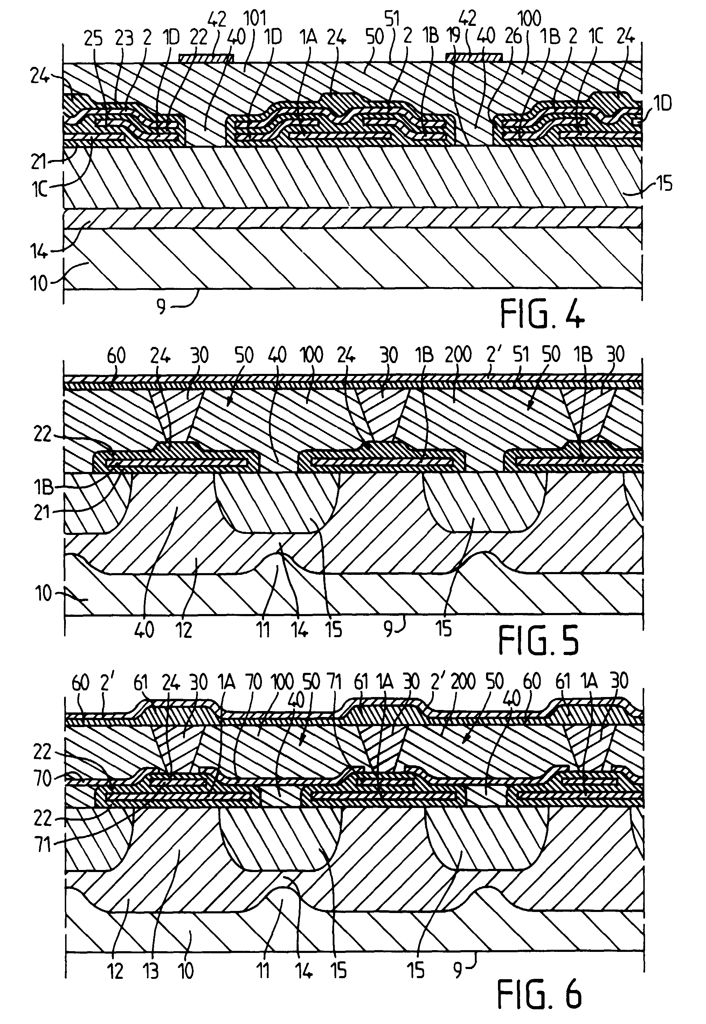

L'arrangement d'électrodes comporte, pour un dispositif à entrelacement et à quatre phases, des groupes d'électrodes 1A, 1B, 1C et 1D (voir la figure 4) perpendiculaires aux canaux 15 et répartis de manière répétitive sur toute la longueur des canaux 15, et isolées électriquement par des couches de SiO₂ 21, 22 et 23 ainsi qu'il est classique pour les dispositifs à transfert de trame. Une cellule élémentaire comporte alors deux régions de fenêtre (100, 101). L'ensemble de l'arrangement d'électrodes est recouvert par une électrode 2 dont la fonction est de diminuer ou même d'éviter le phénomène de brouillage d'image. En d'autres termes, l'électrode 2 surmonte toute la face supérieure 19 à l'exception des fenêtres 40 et des bords 26 des couches d'oxyde qui l'entourent et l'isolent électriquement des électrodes. Lors de la phase de transfert d'image, l'électrode 2 est polarisée positivement. Il en résulte que les électrons produits lors de la phase de transfert de trame sont attirés par l'électrode 2 et sont retenus par celle-ci. Ceci évite, pour les points pour lesquels l'intensité lumineuse est élevée, que les charges engendrées pendant la phase de transfert de charge n'atteignent les canaux 15 pendant le transfert de charge.

Après la phase de transfert de charges, l'électrode 2 est portée à un potentiel négatif ou nul, et les électrons précédemment retenus par l'électrode 2 sont libérés et peuvent s'écouler vers les canaux 15 de même que ceux qui sont produits pendant la phase d'intégration.

En outre, l'électrode 2 peut être réfléchissante. Ceci permet d'éviter que des charges électriques soient crées dans le substrat, en particulier par la partie rouge du spectre susceptible d'atteindre directement les canaux 15.

Pour éviter une dérive des charges de la couche photosensible 50 d'une région de fenêtre à l'autre, la couche d'oxyde 23 présente des bandes d'oxyde 24 formant un réseau à deux dimensions, l'une parallèle aux canaux 15 et l'autre perpendiculaire à ceux-ci, et délimitant le périmètre des régions de fenêtre (100, 101) de la couche photosensible 50.

En outre, étant donné que les photons incidents sur la couche 50 produisent des paires électron-trou, dont les électrons sont recueillis dans les canaux de type n, les trous sont recueillis par des bandes conductrices 30 disposées à la surface de la couche 50 et s'étendant selon au moins une direction sur le contour des régions de fenêtre et bordant au moins un côté de chaque région de fenêtre.

A titre d'exemple, la couche 50 a une épaisseur de 1,5 µm, les couches d'oxyde 21, 22 et 23 une épaisseur respectivement de 0,1, 0,2, et 0,1 µm les bandes d'oxyde 24, une épaisseur de 0,5 µm, et les électrodes 1A à 1D et 2 sont en polysilicium très dopé d'épaisseur 0,3 µm.

Selon la figure 3, l'électrode 2 est réfléchissante et la couche photosensible 50 présente à sa surface 51 des ilôts 42 non transparents, c'est-à-dire soit absorbants, soit réfléchissants surplombant les fenêtres 40 et de dimensions égales ou légèrement supérieures à celles-ci. Le rayonnement incident est alors totalement empêché d'atteindre directement les canaux 15, d'où suppression quasi-totale du brouillage d'image.

La figure 4 montre plus particulièrement l'agencement des électrodes 1A à 1D et 2.

Un premier niveau est constitué par les électrodes 1A et 1C isolées de la surface 19 par une couche isolante 21. Un deuxième niveau est constitué par les électrodes 1B et 1D séparées de la surface 19 par la couche isolante 21 dans leur région centrale qui borde la fenêtre 40 et dont les bords latéraux chevauchent les électrodes 1A et 1C, ces bords latéraux étant isolés électriquement de ces dernières électrodes par une couche isolante 25.

Enfin, un troisième niveau est constitué par l'électrode 2 recouvrant l'ensemble à l'exception des fenêtres 40 et des bords 26 des couches d'oxyde qui entourent complètement les fenêtres 40 pour les isoler des électrodes 1A à 1D et 2.

Etant donné que la fonction des fenêtres 40 est simplement de laisser passer les électrons produits dans la couche 50 vers les canaux 15, leur dimension est avantageusement aussi petite que le permet le procédé de fabrication, par exemple 2 µm x 2 µm pour une épaisseur qui est celle de l'arrangement d'électrode y compris les électrodes 2 soit en tout 1 µm dans l'exemple cité plus haut. On évite ainsi de perturber le potentiel créé au niveau des canaux 15 par les électrodes 1B et 1D.

En outre, les bandes conductrices 30 dont la fonction est l'évacuation de charges (trous) peuvent également avoir une largeur aussi faible que permet le procédé de fabrication (par exemple 1 à 2 µm). Cette largeur est notablement inférieure à celle des zones 13 d'interruption de canal dont la largeur est d'environ 4 µm, pour un entr'axe entre les canaux de l'ordre de 10 µm.

Il apparaît donc la surface photoconductrice est notablement plus grande que dans les dispositifs à transfert de trame de l'art antérieur. En outre, l'efficacité est meilleure en raison du fait que le rayonnement incident frappe directement la couche photosensible 50.

Selon la figure 5, une électrode 2' remplissant la même fonction de correction de brouillage d'image que l'électrode 2, est transparente et recouvre entièrement la surface supérieure 51 de la couche photosensible 50, dont elle est séparée par une couche isolante par exemple de SiO₂ 60. Pour diminuer encore plus le brouillage d'image, les électrodes 1A à 1D sont avantageusement réfléchissantes.

Selon la figure 6, la couche d'oxyde 60 présente, sur le contour des régions de fenêtre (100, 200) et débordant de celui-ci, un réseau à deux dimensions de bandes d'oxyde plus épaisses 61. Ces bandes d'oxyde contribuent à éviter une dérive des charges sur la surface 51 entre les régions de fenêtre (100, 200). Ces bandes d'oxydes peuvent être omises là où sont présentes des bandes conductrices 30, celles-ci permettent également d'éviter une dérive des charges (électrons) entre les régions de fenêtre.

La correction de brouillage d'image est réalisée grâce à des ilôts conducteurs et réfléchissants 70 par exemple en Mo ou Al, à raison d'un par région de fenêtre, isolés électriquement les uns des autres et s'étendant à la surface de la couche isolante 22 et sur les fenêtres 40.

En outre, une couche réfléchissante 71 formant un réseau à deux dimensions est avantageusement noyée dans les bandes isolantes 24 de manière à être situées à l'aplomb des zones séparant les îlots 70 et en débordant légèrement de celles-ci. La couche 2' permet de retenir dans la couche 50 les électrons produits lors de la phase de transfert de charge, et les îlots 70 empêchent que le rayonnement atteigne directement les canaux 15 qui, bien que n'ayant qu'une fonction de transfert de charges, présentent cependant une certaine photoconductivité . Les ilôts étant conducteurs, les électrons produits dans les régions de fenêtre (100, 200) de la couche 50 transitent normalement, lors de la phase d'intégration vers les canaux 15 à travers la partie centrale des ilôts conducteurs 70 et les fenêtres 40. Enfin, la couche réfléchissante 71, qui peut être ou conductrice ou non conductrice, permet de parachever la protection du substrat contre le rayonnement susceptible de l'atteindre directement.

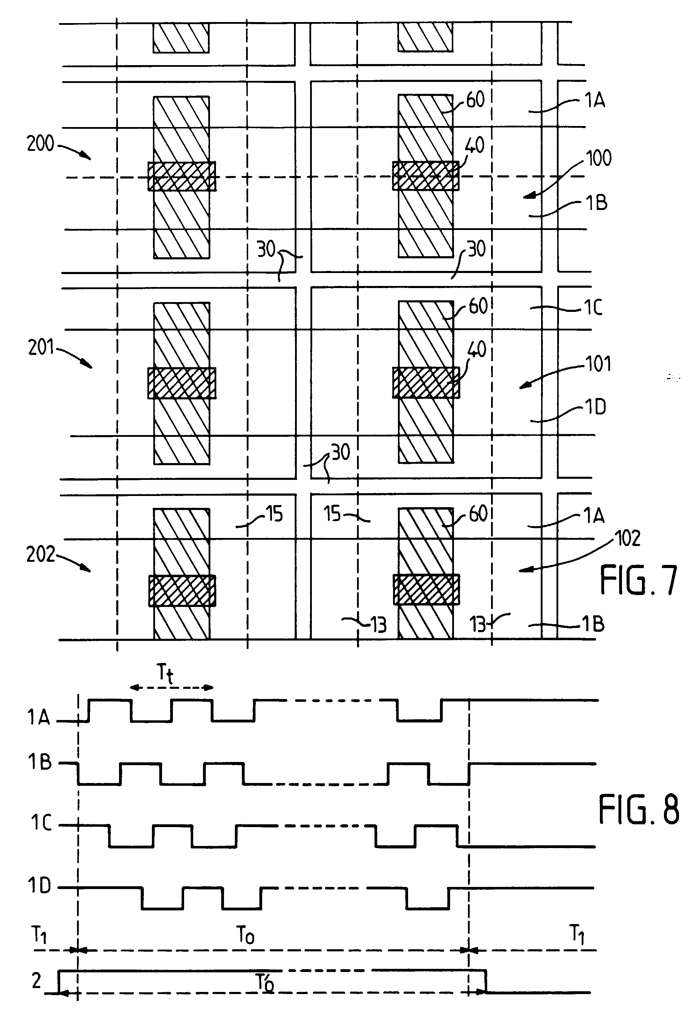

Selon la figure 7, on a représenté les bandes conductrices 30 comme un réseau à deux dimensions bordant la totalité du pourtour des régions de fenêtre (100, 101, 200, 201). On comprendra que leur fonction de recueil des charges peut être remplie si les bandes conductrices bordent au moins un côté de chacune des régions de fenêtre. La figure 7 correspond à un système à quatre phases (électrodes 1A à 1D) mis en oeuvre pour une image à entrelacement. Les fenêtres 40 (à raison de deux par cellule élémentaire) ne sont ménagées qu'à travers une électrode sur deux (1B et 1D). Les fenêtres 40 et les portions moins épaisses de la couche 60 ont été représentées par convention par des hachures. Chaque cellule élémentaire comporte deux régions de fenêtre (100, 101), (200, 201) alignées dans la direction de transfert de charge, c'est-à-dire l'axe des canaux 15, et pourvues chacune d'une fenêtre 40.

La figure 8 donne un exemple des signaux des électrodes 1A à 1D pendant une durée d'intégration T₁ et une durée de transfert de charge T₀. Le signal appliqué à l'électrode 2 (ou 2') est positif pendant un intervalle de temps T'₀ débordant légèrement avant et après la durée T₀ de transfert de charge. Pendant la durée d'intégration T₁, les électrodes 1B et 1D, celles qui comportent des fenêtres 40 sont positives, alors que les électrodes 1A et 1C ont des polarités opposées qui s'inversent d'une phase d'intégration à la suivante. Autrement dit, au cours d'une phase d'intégration de durée T₁, seule une des électrodes 1A à 1D est portée à un potentiel négatif et c'est une des électrodes 1A ou 1C, par exemple 1A. Au cycle d'intégration suivant, c'est l'autre des électrodes 1A ou 1C qui est à un potentiel négatif, soit dans cet exemple 1C. Pendant la phase de transfert de charges, les électrodes 1A à 1B sont cadencées à une fréquence de transfert (de période Tₜ) avec un décalage de phase de 90° d'une électrode à l'électrode adjacente. On aura par exemple T₀ = 0,24 ms, T₁ = 19,76 ms et Tₜ = 800.

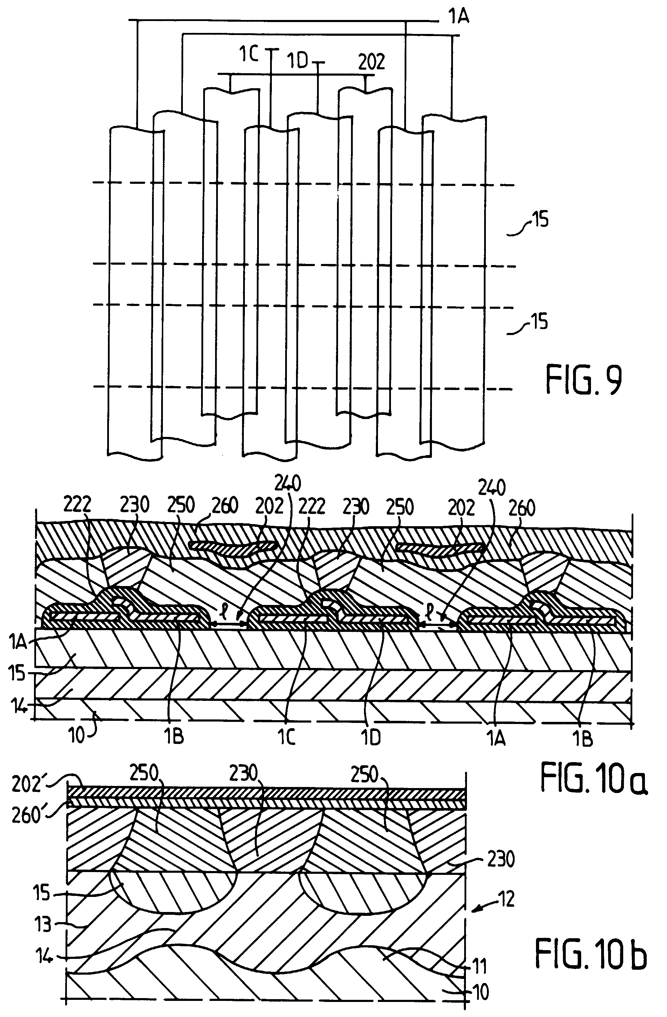

Les figures 9, 10a et 10b montrent un mode de réalisation préféré de l'invention, qui présente la propriété d'être en général de fabrication aisée et qui permet d'assurer le cas échéant de bonnes propriétés de correction de brouillage d'image.

Comme dans les figures précédentes, le dispositif présente une région 10 de type n⁻, pourvue éventuellement de profils longitudinaux 11, et une région 12, de type p⁻ présentant des portions 13 situées entre des canaux longidudinaux 15 de type n servant au transfert des charges.

La différence essentielle avec les figures précédentes est que des fenêtres ne sont plus ouvertes au niveau de chaque cellule élémentaire, mais que des bandes situées entre des électrodes adjacentes des électrodes de transfert de charge (1A à 1D) s'étendent sur toute la longueur de ces électrodes, et sont constituées par des prolongements de la couche photosensible proprement dite 250.

La figure 10a montre de telles bandes 240 s'étendant entre des groupes de deux électrodes respectivement (1A, 1B) et (1C, 1D) noyées dans un matériau isolant (222), ainsi que des bandes conductrices 230 de type p⁺. La largeur 1 des bandes 240 peut être aussi faible que le permet le procédé de fabrication, soit par exemple 1 µm. Elles sont avantageusement non transparentes pour une suppression optimale du brouillage d'image. Des bandes conductrices 230 de type p⁺ sont disposées au-dessus de l'oxyde 222 et s'étendent parallèlement aux électrodes de transfert de charges (1A à 1D), jusqu'à la surface de la couche 250 de manière à confiner les porteurs de charges libres en des endroits spécifiques. Ce confinement est complété grâce à des régions p⁺ formant avec les bandes 230 un réseau rectangulaire à deux dimensions couvrant toute la surface du dispositif et interrompant localement les bandes 240 à chaque cellule élémentaire, dans la direction de transfert de charges. Les coupes 10a et 10b diffèrent légèrement entre elles en ce que dans la figure 10a, des bandes d'électrodes 202 sont noyées dans une couche isolante 260 disposée sur la surface supérieure du dispositif capteur alors qu'à la figure 10b, une électrode transparente 202', par exemple en oxyde de plomb Indium (TIO), recouvre une couche isolante 260' disposée à la surface supérieure du dispositif capteur, ce qui assure une plus grande sensibilité lumineuse.

Les régions conductrices étant réalisées dans une couche de Si recristallisé, (d'épaisseur de l'ordre de 1 à 2 µm) les bandes 240 peuvent être réalisées par recristallisation au laser par balayage dans la direction des électrodes de transfert de charges. Les régions p⁺230, réalisées par implantation, aident à diminuer le courant d'obscurité. Les électrodes 1A à 1D peuvent être en métal ou en molybdène. La dimension d'une cellule élémentaire est de l'ordre de 10 à 20 µm parallèlement aux canaux 15 et 5 à 10 µm parallèlement aux électrodes.

Le fonctionnement du capteur est le suivant. Pendant la phase d'intégration, les bandes 202 (ou l'électrode 202' selon le cas) sont portées à un potentiel négatif. Lorsque les électrodes 1C et 1D sont à un potentiel positif, et les électrodes 1A et 1B à un potentiel négatif, les charges traversent les bandes 240 et se stockent sous les électrodes 1C et 1D. Lorsque les électrodes 1A et 1B sont à un potentiel positif, et les électrodes 1C et 1D à un potentiel négatif, les charges traversent les bandes 240 et se stockent sous les électrodes 1A et 1B. Les charges stockées sous les bandes 240 situées entre les électrodes 1B et 1C et sous les bandes 240 situées entre les électrodes 1D et 1A sont dérivées dans des directions opposées (entrelacement). Pendant la phase de transfert de charges, les bandes 202 (ou l'électrode 202' selon le cas) sont portées à un potentiel positif, ce qui leur permet d'attirer temporairement les porteurs de charges libres et d'éviter l'effet d'éblouissement.

L'invention ne se limite pas aux modes de réalisation décrits et représentés. L'enlèvement des charges libres et la séparation des électrons d'une cellule à l'autre peuvent être obtenus uniquement à l'aide de bandes conductrices du second type de conductivité, formant un réseau à deux dimensions entourant les cellules élémentaires. Une autre possibilité est d'avoir des bandes isolantes bordant les cellules élémentaires dans une direction et des bandes conductrices bordant les cellules élémentaires dans l'autre direction.

## Revendications

1. Dispositif capteur d'images à transfert de trames comportant un substrat semi-conducteur présentant une première région (10) d'un premier type de conductivité, une deuxième région (12) d'un deuxième type de conductivité opposé au premier, disposée au-dessus de la première région du substrat et s'étendant jusqu'à la face supérieure (19) du substrat, des canaux (15) parallèles de transfert de charges du premier type de conductivité disposés dans la deuxième région à la face supérieure du substrat selon une direction de transfert de charges, ainsi qu'un arrangement d'électrodes (1A, 1B, 1C, 1D) de transfert de charges disposées perpendiculairement aux canaux (15) parallèles sur la face supérieure du substrat et isolées électriquement de celle-ci, l'arrangement d'électrodes (1A, 1B, 1C, 1D) présentant un arrangement de fenêtres (40, 240), de manière à permettre, lorsque les électrodes sont portées à des potentiels appropriés, le transfert de charges d'un premier signe, stockées dans des cellules élémentaires en réponse à une lumière incidente, dans la direction de transfert de charges le long desdits canaux parallèles caractérisé en ce qu'il comporte une couche photosensible (50, 250) qui recouvre l'arrangement d'électrodes (1A, 1B, 1C, 1D) et en est électriquement isolée, en ce qu' au moins une région de fenêtre (100, 101, 200, 201) de la couche photosensible est, pour chaque cellule élémentaire, localement en contact électrique avec un des canaux parallèles (15) à travers les fenêtres (40, 240) formées dans l'arrangement d'électrodes, en ce qu'à l'arrangement d'électrodes (1A, 1B, 1C, 1D) est superposé un réseau de bandes séparatrices (24, 30) disposées sur la totalité du contour des régions de fenêtre (100, 101, 200, 201), de manière à éviter la dérive des charges du premier signe entre les régions de fenêtre (100, 101, 200, 201), et à évacuer les charges du deuxième signe opposé au premier, ledit réseau présentant des bandes conductrices (30) du deuxième type de conductivité bordant selon au moins une direction les régions de fenêtres (100, 101, 200, 201) de l'arrangement de fenêtres, et en ce qu'à l'arrangement d'électrodes (1A, 1B, 1C, 1D) de transfert de charges est superposée au moins une électrode supérieure (2, 2', 202, 202') isolée électriquement des électrodes de transfert de charges et de la couche photosensible (50,250) et connectée à une source de tension fournissant un premier potentiel du premier signe et un deuxième potentiel du deuxième signe, de manière à diminuer le brouillage d'image lorsque l'électrode supérieure est portée au premier potentiel du premier signe lors d'une phase d'intégration d'image et au deuxième potentiel du deuxième signe lors d'une phase de transfert de charges.

2. Dispositif selon la revendication 1, caractérisé en ce qu'il est du type à entrelacement et en ce que l'arrangement d'électrodes (1A, 1B, 1C, 1D) présente deux fenêtres (100,101) pour chaque cellule élémentaire, qui sont localisées sur deux électrodes de transfert de charges non adjacentes (1B, 1D) et séparées par au moins une électrode de transfert de charges (1A, 1C).

3. Dispositif selon la revendication 1, caractérisé en ce que l'arrangement des fenêtres présente des bandes (240) parallèles aux électrodes de transfert de charges de l'arrangement d'électrodes, chaque bande (240) de l'arrangement de fenêtres étant disposée dans un intervalle entre deux électrodes de transfert de charges (1B, 1C; 1D, 1A) et lesdites bandes (240) étant interrompues entre les cellules élémentaires par celles desdites bandes séparatrices (230) qui sont parallèles à la direction de transfert de charges.

4. Dispositif selon une des revendications précédentes, caractérisé en ce que la couche photosensible (50) est constituée d'une couche de Si dopé recristallisé, le substrat étant également en Si.

5. Dispositif selon la revendication 1, caractérisé en ce que ladite électrode supérieure (2) est réfléchissante et disposée sous la couche photosensible (50).

6. Dispositif selon la revendication 5, caractérisé en ce qu'à la surface (51) de la couche photosensible (50) et à l'aplomb des fenêtres (40) sont disposés des îlots (42) non transparents débordant sensiblement desdites zones de contact.

7. Dispositif selon une des revendications 1 à 4, caractérisé en ce que ladite électrode supérieure (2', 202') est transparente et disposée sur au moins une partie de la surface de la couche photosensible (50, 250) et isolée électriquement de celle-ci.

8. Dispositif selon la revendication 7, caractérisé en ce qu'entre la couche photosensible (50) et l'arrangement d'électrodes (1A, 1B, 1C, 1D) et électriquement isolée de ce dernier, est disposée à chaque région de fenêtre (100, 101, 200, 201) une région conductrice réfléchissante (70) en contact électrique avec la région de fenêtre (100, 101, 200, 201) correspondante, les régions conductrices (70) étant séparées entre elles selon ledit réseau de bandes séparatrices (24,30).

9. Dispositif selon la revendication 8, caractérisé en ce qu'à l'aplomb des bandes séparatrices (24,30) sont disposées des lignes réfléchissantes (71).

10. Dispositif selon la revendication 9, caractérisé en ce que les lignes réfléchissantes (71) sont disposées en dessous des bandes séparatrices (24,30) et sont noyées dans un matériau isolant (22).

## Patentansprüche

1. Bildaufnahmeanordnung mit Halbbildübertragung, die ein Halbleitersubstrat umfaßt, das eine erste Region (10) mit einem ersten Leitfähigkeitstyp hat, eine zweite Region (15) mit einem zweiten, dem ersten entgegengesetzten Lätfähigkeitstyp, die über der ersten Region des Substrats angebracht ist und bis zur Oberseite (19) des Substrats reicht, parallele Kanäle (15) zur Übertragung von Ladungen des ersten Leitfähigkeitstyps, die in der zweiten Region an der Oberseite des Substrats in einer Übertragungsrichtung von Ladungen angebracht sind, sowie mit einer Anordnung von Ladungsübertragungselektroden (1A, 1B, 1C, 1D), die senkrecht zu den parallelen Kanälen (15) auf der Oberseite des Substrats angebracht und von diesen elektrisch isoliert sind, wobei die Elektrodenanordnung (1A, 1B, 1C, 1D) eine Anordnung von Fenstern (40, 240) aufweist, so daß bei Anliegen der Eletroden an geeigneten Potentialen die Übertragung von Ladungen mit einem ersten Vorzeichen, die in Einzelzellen als Reaktion auf einfallendes Licht gespeichert worden sind, in die Übertragungsrichtung von Ladungen entlang der genannten parallelen Kanäle ermöglicht wird, dadurch gekennzeichnet, daß sie eine photoempfindliche Schicht (50, 250) umfaßt, die die Elektrodenanordnung (1A, 1B, 1C, 1D) bedeckt und von dieser elektrisch isoliert ist, daß wenigstens eine Fensterregion (100, 101, 200, 201) der photoempfindlichen Schicht für jede Einzelzelle lokal durch die in der Elektrodenanordnung gebildeten Fenster (40, 240) hindurch in elektrischem Kontakt mit einem der parallelen Kanäle (15) steht, daß der Elektrodenanordnung (1A, 1B, 1C, 1D) ein Gitter aus Trennstreifen (24,30) überlagert ist, die auf der Gesamtheit des Umrisses der Fensterregionen (100, 101, 200, 201) angebracht sind, um die Drift der Ladungen mit dem ersten Vorzeichen zwischen den Fensterregionen (100, 101, 200, 201) zu verhindern und die Ladungen mit dem zweiten, dem ersten entgegengesetzten Vorzeichen zu evakuieren, wobei das genannte Gitter leitende Streifen (30) mit dem zweiten Leitfähigkeitstyp aufweist, die die Fensterregionen (100, 101, 200, 201) der Fensteranordnung in wenigstens einer Richtung einfaßt, und daß der Anordnung aus Ladungsübertragungselektroden (1A, 1B, 1C, 1D) wenigstens eine obere Elektrode (2, 2', 202, 202') überlagert ist, die von den Ladungsübertragungselektroden und der photoempfindlichen Schicht (50, 250) elektrisch isoliert und mit einer Spannungsquelle verbunden ist, die ein erstes Potential mit dem ersten Vorzeichen und ein zweites Potential mit dem zweiten Vorzeichen liefert, um den Bildnebel zu verringern, wenn die obere Elektrode bei einer Bildintegrationsphase an das erste Potential mit dem ersten Vorzeichen und an das zweite Potential mit dem zweiten Vorzeichen bei einer Ladungsübertragungsphase angelegt wird.

2. Anordnung nach Anspruch 1, dadurch gekennzeichnet, daß sie vom Zeilensprungtyp ist und daß die Elektrodenanordnung (1A, 1B, 1C, 1D) zwei Fenster (100, 101) für jede Einzelzelle aufweist, die sich auf zwei nicht-benachbarten Ladungsübertragungselektroden (1B, 1D) befinden und durch wenigstens eine Ladungsübertragungselektrode (1A, 1D) getrennt sind.

3. Anordnung nach Anspruch 1, dadurch gekennzeichnet, daß die Fensteranordnung zu den Ladungsübertragungselektroden der Elektrodenanordnung parallele Streifen (240) aufweist, wobei jeder Streifen (240) der Fensteranordnung in einem Intervall zwischen zwei Ladungsübertragungselektroden (1B, 1C, 1D, 1A) angebracht ist und die genannten Streifen (240) zwischen den Einzelzellen von denjenigen der genannten Trennstreifen (230) unterbrochen werden, die parallel zur Ladungsübertragungsrichtung verlaufen.

4. Anordnung nach einem der vorgenannten Ansprüche, dadurch gekennzeichnet, daß die photoempfindliche Schicht (50) aus einer Schicht aus dotiertem, rekristallisiertem Si besteht, wobei das Substrat ebenfalls aus Si ist.

5. Anordnung nach Anspruch 1, dadurch gekennzeichnet, daß die genannte obere Elektrode (2) reflektierend und unter der photoempfindlichen Schicht (50) angebracht ist.

6. Anordnung nach Anspruch 5, dadurch gekennzeichnet, daß auf der Oberfläche (51) der photoempfindlichen Schicht (50) und senkrecht zu den Fenstern (40) nicht-transparente Inseln angebracht sind, die im wesentlichen über die genannten Kontaktzonen hinausreichen.

7. Anordnung nach einem der Ansprüche 1 bis 4, dadurch gekennzeichnet, daß die genannte obere Elektrode (2', 202') transparent ist, wenigstens auf einem Teil der Oberfläche der photoempfindlichen Schicht (50, 250) angebracht und von dieser elektrisch isoliert ist.

8. Anordnung nach Anspruch 7, dadurch gekennzeichnet, daß zwischen der photoempfindlichen Schicht (50) und der Elektrodenanordnung (1A, 1B, 1C, 1D) und von letzterer elektrisch isoliert an jeder Fensterregion (100, 101, 200, 201) eine leitende reflektierende Region (70) angebracht ist, die in elektrischem Kontakt mit der entsprechenden Fensterregion (100, 101, 200, 201) steht, wobei die leitenden Regionen (70) voneinander durch das genannte Gitter von Trennstreifen (24, 30) getrennt sind.

9. Anordnung nach Anspruch 8, dadurch gekennzeichnet, daß senkrecht zu den Trennstreifen (24,30) reflektierende Leitungen (71) angebracht sind.

10. Anordnung nach Anspruch 9, dadurch gekennzeichnet, daß die reflektierenden Leitungen unter den Trennstreifen (24, 30) angebracht und in ein isolierendes Material (22) eingelassen sind.

## Claims

1. An image sensor device of the frame transfer type comprising a semiconductor substrate having a first region (10) of a first conductivity type, a second region (12) of a second conductivity type opposed to the first arranged above the first region of the substrate and extending up to the upper surface (19) of the substrate, parallel charge transfer channels (15) of the first conductivity type arranged in the second region at the upper surface of the substrate in a direction of charge transfer, and an arrangement of charge transfer electrodes (1A, 1B, 1C, 1D) provided perpendicularly to the parallel channels (15) at the upper surface of the substrate and electrically insulated therefrom, the arrangement of electrodes (1A, 1B, 1C, 1D) comprising an arrangement of windows (40, 240) such that they permit, when the electrodes are brought to suitable potentials, the transfer of charges of a first sign stored in elementary cells in response to incident light in the direction of charge transfer along said parallel channels, characterized in that it comprises a photosensitive layer (50, 250) which covers the arrangement of electrodes (1A, 1B, 1C, 1D) and is electrically insulated therefrom, in that for each elementary cell there is at least one window region (100, 101, 200, 201) of the photosensitive layer which is locally in electrical contact with one of the parallel channels (15) via the windows (40, 240) formed in the arrangement of electrodes, in that superimposed on the arrangement of electrodes (1A, 1B, 1C, 1D) there is a network of separation strips (24, 30) disposed on the entire outline of the window regions (100, 101, 200, 201) so as to avoid a drift of charges of the first sign between the window regions (100, 101, 200, 201) and to drain off the charges of the second sign opposed to the first, said network comprising conductive strips (30) of the second conductivity type adjoining the window regions (100, 101, 200, 201) of the arrangement of windows in at least one direction, and in that at least one upper electrode (2, 2', 202, 202') is superimposed on the arrangement of charge transfer electrodes (1A, 1B, 1C, 1D), is electrically insulated from the charge transfer electrodes (1A, 1B, 1C, 1D) and from the photosensitive layer (50, 250), and is connected to a voltage source supplying a first potential of the first sign and a second potential of the second sign so as to reduce the image smear when the upper electrode is brought to the first potential of the first sign during an image integration phase and to the second potential of the second sign during a charge transfer phase.

2. A device as claimed in Claim 1, characterized in that it is of the interlacing type and in that the arrangement of electrodes (1A, 1B, 1C, 1D) has two windows (100, 101) for each elementary cell, which are located on two non-adjacent charge transfer electrodes (1B, 1D) are separated by at least one charge transfer electrode (1A, 1C).

3. A device as claimed in Claim 1, characterized in that the arrangement of windows has strips (240) parallel to the charge transfer electrodes of the arrangement of electrodes, each strip (240) of the arrangement of windows being disposed in a space between two charge transfer electrodes (1B, 1C, 1D, 1A) and the said strips (240) being interrupted between the elementary cells by those of said separation strips (230) which are parallel to the direction of charge transfer.

4. A device as claimed in any one of the preceding Claims, characterized in that the photosensitive layer (50) is formed by a layer of doped recrystallized Si, the substrate also consisting of Si.

5. A device as claimed in Claim 1, characterized in that the said upper electrode (2) is reflective and is arranged under the photosensitive layer (50).

6. A device as claimed in Claim 5, characterized in that non-transparent islands (42) projecting slightly from the said contact zones are arranged at the surface (51) of the photosensitive layer (50) and at right angels to the windows (40).

7. A device as claimed in any one of Claims 1 to 4, characterized in that the said upper electrode (2', 202') is transparent, is arranged on at least part of the surface of the photosensitive layer (50, 250), and is electrically insulated therefrom.

8. A device as claimed in Claim 7, characterized in that arranged between the photosensitive layer (50) and the arrangement of electrodes (1A, 1B, 1C, 1D) so as to be electrically insulated therefrom there is at each window region (100, 101, 200, 201) a conductive reflecting region (70) in electrical contact with the corresponding window region (100, 101, 200, 201), the conductive regions (70) being separated from each other by said network of separation strips (24, 30).

9. A device as claimed in Claim 8, characterized in that reflective lines (71) are arranged at right angles to the separation strips (24, 30).

10. A device as claimed in Claim 9, characterized in that the reflective lines (71) are arranged under the separation strips (24, 30) and are embedded in an insulating material (22).
